# EUROPEAN PATENT SPECIFICATION

(11) **EP 2 851 768 B1**
(45) Date of publication and mention of the grant of the patent: **12.04.2017**
(21) Application number: 13194149.4
(22) Date of filing: 22.11.2013
(51) Int. Cl.: G06F 3/044, H01L 27/32

(54) **Transparent conductive structure having metal mesh**
Transparente leitfähige Struktur mit Metallnetz
Structure de conducteur transparent ayant un treillis métallique

(30) Priority: 18.09.2013 TW 102133934; 14.11.2013 TW 102141467
(43) Date of publication of application: 25.03.2015
(73) Proprietor: Flex Tek Co., Ltd., Taoyuan City 328 (TW)
(72) Inventor: Tsai, Sui-Ho, Taoyuan Hsien (TW)
(74) Representative: Becker Kurig Straus

(56) References cited:
- EP-A1- 2 139 010
- WO-A1-2013/008827

## Description

### BACKGROUND

### Technical Field

The present disclosure relates to a transparent conductive structure, and more particularly, to a transparent conductive structure for a sensor of a touch device and a method for manufacturing the same.

### Description of Related Art

Currently, touch panels have been wildly applied in various electric devices such as mobile devices, computers and digital cameras. The technologies for fabricating a small-size touch panel are quite mature, and the small-size touch panel is capable of fitted into many kinds of electric products equipped with a small display.

In a general touch panel, indium-tin-oxide (ITO) is used as a main transparent conductive material. However, compared to the conductivity of metals, the surface resistance (100-400 Ω/□) and line resistance (10,000-50,000 Ω) of ITO are much higher. The total surface resistance of the touch panel significantly increases while the area thereof becomes greater. As such, the touch panel may have the lower response rate and poorer sensitivity.

In the touch panel, a transparent conductive structure having a metal mesh, such as graphene, carbon nanotube CNT or silver nanowire, is replacing the ITO material. However, the cost of the general transparent conductive structure is too high for mass production. In this regard, the transparent conductive structure with a metal mesh generally has a metal layer made from silver as a conductive Touch panels with metal mesh electrodes are disclosed in International Publication WO 2013/008827.

However, besides the expansive cost, silver is easy to be oxidized or sulfidized, which increases the surface resistance of the transparent conductive structure and even breaks and fail the electrical circuitry. Therefore, there is a need for an improved transparent conductive structure and a method for manufacturing thereof, so as to solve the aforementioned problems met in the art.

### SUMMARY

The present disclosure provides a transparent conductive structure using copper to form a conductive layer as described in claim 1.

The transparent conductive structure of the present invention comprises a transparent substrate, a first mesh structure and a second mesh structure, wherein the transparent substrate has a top surface and a bottom surface opposite to the top surface.

The first mesh structure is positioned on the top surface of the transparent substrate. The first mesh structure from the top surface of the transparent substrate sequentially comprises a tie coat layer, a first dielectric layer, a first metal layer and a first anti-reflective layer. The first metal layer is positioned on the first dielectric layer, and the first anti-reflective layer is positioned on the first metal layer.

The second mesh structure is positioned on the bottom surface of the transparent substrate. The second mesh structure from the bottom surface of the transparent substrate sequentially comprises a tie coat layer, second dielectric layer, a second metal layer and a second anti-reflective layer. The second metal layer is positioned on the second dielectric layer, and the second anti-reflective layer is positioned on the second metal layer.

According to one example of the present disclosure, the line widths of the first mesh structure and the second mesh structure are about 2-15 µm.

According to one example of the present disclosure, the transparent substrate is a rigid substrate or a flexible substrate. According to one example of the present disclosure, the rigid substrate comprises glass, fiber-glass or hard plastic. According to one example of the present disclosure, the flexible substrate comprises polyethylene (PE), polyethylene terephthalate (PET) or tri-acetyl cellulose (TAC).

According to the present invention, the materials of the first dielectric layer and the second dielectric layer are a zinc-copper alloy.

According to one example of the present disclosure, the thicknesses of the first dielectric layer and the second dielectric layer are about 1-200 nm.

According to one example of the present disclosure, the first dielectric layer and the second dielectric layer are in blue, deep-blue or black.

According to the present invention, the materials of the first anti-reflective layer and the second anti-reflective layer are nickel zinc sulfide.

According to one example of the present disclosure, the thicknesses of the first anti-reflective layer and the second anti-reflective layer are about 5-1,000 nm.

According to one example of the present disclosure, the first anti-reflective layer and the second anti-reflective layer are in blue, deep-blue or black.

According to the present invention, the materials of the first metal layer and the second metal layer are copper (Cu).

According to one example of the present disclosure, the thicknesses of the first metal layer and the second metal layer are about 0.2-3.0 µm.

According to one example of the present disclosure, the first mesh structure and the second mesh structure are in a grid pattern, a rhombus pattern or a square-cell pattern.

According to the present invention, the first mesh structure comprises a first tie coat layer sandwiched between the top surface of the transparent substrate and the first dielectric layer; and the second mesh structure comprises a second tie coat layer sandwiched between the bottom surface of the transparent substrate and the second dielectric layer.

According to the present invention, the materials of the first tie coat layer and the second tie coat layer are a nickel-chromium alloy.

According to one example of the present disclosure, the thicknesses of the first tie coat layer and the second tie coat layer are about 1-200 nm.

According to one example of the present disclosure, the first mesh structure further comprises a first passivation layer covering the first anti-reflective layer; and the second mesh structure further comprises a second passivation layer covering the second anit-reflective layer.

According to one example of the present disclosure, the materials of the first passivation layer and the second passivation layer is an optical clear adhesive (OCA).

According to one example of the present disclosure, the OCA is a transparent acrylic adhesive.

According to one example of the present disclosure, the thicknesses of the first passivation layer and the second passivation layer are about 10-100 µm.

### BRIEF DESCRIPTION OF THE DRAWINGS

For a more complete understanding of the present invention, and the advantages thereof, reference is now made to the following descriptions taken in conjunction with the accompanying drawings, in which:
Fig. 1 is a top view of a transparent conductive structure 100 according to one embodiment of the present disclosure;
Fig. 2 is a cross-sectional view of a transparent conductive structure 200 according to one embodiment not forming part of the present invention; and
Fig. 3 is a cross-sectional view of a transparent conductive structure 300 according to one embodiment of the present disclosure.

### DETAILED DESCRIPTION

The embodiments of the transparent conductive structure and a method for manufacturing the same of the present disclosure are discussed in detail below. The same symbols or numbers are used to the same or similar portion in the drawings or the description. And the applications of the present disclosure are not limited by the following embodiments and examples which the person in the art can apply in the related field.

The singular forms "a," "an" and "the" used herein include plural referents unless the context clearly dictates otherwise. Therefore, reference to, for example, a metal layer includes embodiments having two or more such metal layers, unless the context clearly indicates otherwise. Reference throughout this specification to "one embodiment" means that a particular feature, structure, or characteristic described in connection with the embodiment is included in at least one embodiment of the present disclosure. Therefore, the appearances of the phrases "in one embodiment" or "in an embodiment" in various places throughout this specification are not necessarily all referring to the same embodiment. Further, the particular features, structures, or characteristics may be combined in any suitable manner in one or more embodiments. It should be appreciated that the following figures are not drawn to scale; rather, the figures are intended; rather, these figures are intended for illustration.

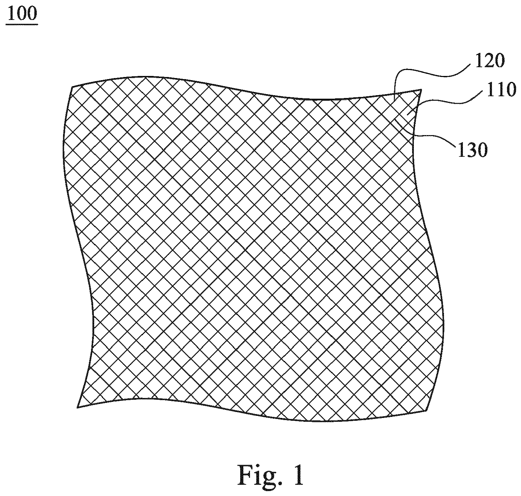

Fig. 1 is a top view of a transparent conductive structure 100 according to one embodiment of the present disclosure. In Fig. 1, the transparent conductive structure 100 comprises a transparent substrate 110, a first mesh structure 130 and a second mesh structure 120.

The first mesh structure 130 has a plurality of conductive wires extended laterally. The second mesh structure 120 has a plurality of conductive wires extended longitudinally. In the top view of the transparent conductive structure 100, the conductive wires of the first mesh structure 130 and the second mesh structure 120 crisscross to form a square-cell pattern. In one embodiment of the present disclosure, the line widths of the conductive wires of the first and second mesh structures are about 2-15 µm, and preferred about 2-8 µm. Because the first and second mesh structures have varied fine conductive wires, it may prevent light to occur moire or interference fringe.

The transparent conductive structure disclosed as various embodiments of the present disclosure can be applied into a touch device or a display device. Because the transparent conductive structure has metal layers, the first and second mesh structure in one embodiment of the present disclosure is needed to perform a darkening treatment, so as to avoid the metal layer generating light reflection to occur chromatic aberration or visible metal wire. Otherwise, because the first and second mesh structures are in deep blue or black, it can be used to absorb reflective light or scattering light, and to prevent light diffraction or moire occurred by the conductive wires.

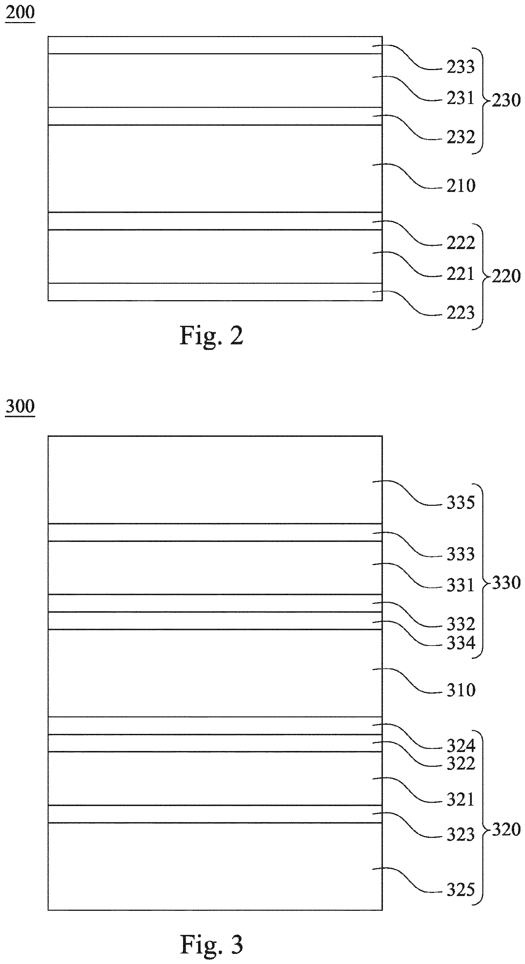

Fig. 2 is a cross-sectional view of a transparent conductive structure 200 not forming part of the present invention. In Fig. 2, the transparent conductive structure 200 comprises a transparent substrate 210, a first mesh structure 230 and a second mesh structure 220.

The transparent substrate 210 has a top surface and a bottom surface. The first mesh structure 230 is positioned on the top surface of the transparent substrate 210; and the second mesh structure 220 is positioned on the bottom surface of the transparent substrate 210. In one embodiment not forming part of the present invention, the transparent substrate is a rigid substrate or a flexible substrate. In one embodiment of the present disclosure, the rigid substrate comprises glass, fiber-glass or a hard plastic. In one embodiment not forming part of the present invention, the flexible substrate comprises polyethylene (PE), polyethylene terephthalate (PET) or tri-acetyl cellulose (TAC).

In Fig. 2, the first mesh structure 230 comprises a first metal layer 231, a first dielectric layer 232 and a first anti-reflective layer 233. In which, the first dielectric layer 232, the first metal layer 231 and the first anti-reflective layer 233 are sequentially positioned on the top surface of the transparent substrate 210.

The second mesh structure 220 comprises a second metal layer 221, a second dielectric layer 222 and a second anti-reflective layer 223. In which, the second dielectric layer 222, the second metal layer 221 and the second anti-reflective layer 223 are sequentially positioned on the bottom surface of the transparent substrate 210.

In one embodiment not forming part of the present invention, the materials of the first and second metal layers are copper (Cu) or silver (Ag). In one embodiment not forming part of the present invention, the thicknesses of the first and second metal layers are about 0.2-3.0 µm. The resistance of copper (Cu) is about 1.678×10⁻⁶ Ω-cm, and much lower than other nonmetal transparent conductive materials. Therefore, if copper can be used to fabricate a conductive film with more than 85% of light-transmittance, the conductive film cab be used as a transparent conductive structure. In various embodiments of the present disclosure, a mesh structure having vary fine metal wires is made from copper, and light can be transmitted through the openings of the mesh structure, so that the mesh structure has better light-transmittance and conductivity at the same device.

In one embodiment not forming part of the present invention, the materials of the first and second dielectric layers are individually a metal, an oxygen-containing metal compound or a sulfur-containing metal compound. It is important that, the oxygen-containing or sulfur-containing metal compounds are oxygen molecules, oxygen atoms or sulfur atoms doped within metal crystals.

When metal crystals are doped with oxygen molecules, oxygen atoms or sulfur atoms, the metal compound may lose metallic luster thereof, and an oxygen-containing or sulfur-containing metal compound in blue, deep-blue or black is obtained. In one embodiment not forming part of the present invention, the metal or the metal compound is one selected from the group consisting of nickel (Ni), titanium (Ti), molybdenum (Mo), chromium (Cr), copper (Cu), zinc (Zn), tin (Sn) and the combinations thereof. In one embodiment not forming part of the present invention, the first and second dielectric layers are in blue, deep-blue or black. In one embodiment not forming part of the present invention, the thicknesses of the first and second dielectric layer are about 1-200 nm.

In one embodiments not forming part of the present invention, the materials of the first and second anti-reflective layers are individually a metal, a metal oxide or a metal sulfide. In one embodiment not forming part of the present invention, the metal is one selected from the group consisting of nickel (Ni), titanium (Ti), molybdenum (Mo), chromium (Cr), copper (Cu), zinc (Zn), tin (Sn), cobalt (Co), tungsten (W), iron (Fe) and the combinations thereof.

Because the metal oxides provided are all in blue, deep-blue or black, the first and second anti-reflective layers containing the same are in blue, deep-blue or black. The thicknesses of the first and second anti-reflective layers are about 5-1,000 nm.

Fig. 3 is a cross-sectional view of a transparent conductive structure 300 according to one embodiment of the present disclosure. In Fig. 3, the transparent conductive structure 300 comprises a transparent substrate 310, a first mesh structure 330 and a second mesh structure 320.

The transparent substrate 310 has a top surface and a bottom surface. The first mesh structure 330 is positioned on the top surface of the transparent substrate 310; and the second mesh structure 320 is positioned on the bottom surface of the transparent substrate 310. In one embodiment of the present disclosure, the transparent substrate is a rigid substrate or a flexible substrate. In one embodiment of the present disclosure, the rigid substrate comprises glass, fiber-glass or a hard plastic. In one embodiment of the present disclosure, the flexible substrate comprises polyethylene (PE), polyethylene terephthalate (PET) or tri-acetyl cellulose (TAC).

In Fig. 3, the first mesh structure 330 comprises a first metal layer 331, a first dielectric layer 332, a first anti-reflective layer 333, a first tie coat layer 334 and a first passivation layer 335. In which, the first tie coat layer 334, the first dielectric layer 332, the first metal layer 331, the first anti-reflective layer 333 and the first passivation layer 335 are sequentially positioned on the top surface of the transparent substrate 310.

The second mesh structure 320 comprises a second metal layer 321, a second dielectric layer 322, a second anti-reflective layer 223, a second tie coat layer 324 and a second passivation layer 325. In which, the second tie coat layer 324, the second dielectric layer 322, the second metal layer 321, the second anti-reflective layer 323 and the second passivation layer 325 are sequentially positioned on the bottom surface of the transparent substrate 310.

In one embodiment of the present disclosure, the materials of the first and second metal layers are copper (Cu) or silver (Ag). In one embodiment of the present disclosure, the thicknesses of the first and second metal layers are about 0.2-3.0 µm.

In one embodiment of the present disclosure, the materials of the first and second dielectric layers are individually a metal, an oxygen-containing metal compound or a sulfur-containing metal compound. It is important that, the oxygen-containing or sulfur-containing metal compounds are oxygen molecules, oxygen atoms or sulfur atoms doped within metal crystals.

When metal crystals are doped with oxygen molecules, oxygen atoms or sulfur atoms, the metal compound may lose metallic luster thereof, and an oxygen-containing or sulfur-containing metal compound in blue, deep-blue or black is obtained. In one embodiment of the present disclosure, the metal or the metal compound is one selected from the group consisting of nickel (Ni), titanium (Ti), molybdenum (Mo), chromium (Cr), copper (Cu), zinc (Zn), tin (Sn) and the combinations thereof. In one embodiment of the present disclosure, the first and second dielectric layers are in blue, deep-blue or black. In one embodiment of the present disclosure, the thicknesses of the first and second dielectric layer are about 1-200 nm.

In one embodiment of the present disclosure, the materials of the first and second anti-reflective layers are individually a metal, a metal oxide or a metal sulfide. In one embodiment of the present disclosure, the metal is one selected from the group consisting of nickel (Ni), titanium (Ti), molybdenum (Mo), chromium (Cr), copper (Cu), zinc (Zn), tin (Sn), cobalt (Co), tungsten (W), iron (Fe) and the combinations thereof.

Because the metal oxides provided in embodiments of the present disclosure are all in blue, deep-blue or black, the first and second anti-reflective layers containing the same are in blue, deep-blue or black. In one embodiment of the present disclosure, the thicknesses of the first and second anti-reflective layers are about 5-1,000 nm.

In one embodiment of the present disclosure, the materials of the first and second tie coat layers are individually a metal, an oxygen-containing metal compound or a sulfur-containing metal compound. In one embodiment of the present disclosure, the metal or the metal compound is one selected from the group consisting of nickel (Ni), titanium (Ti), molybdenum (Mo), chromium (Cr), copper (Cu), zinc (Zn), cobalt (Co), vanadium (V) and the combinations thereof. In one embodiment of the present disclosure, the thicknesses of the first and second tie coat layers are about 1-200 nm.

In one embodiment of the present disclosure, the materials of the first passivation layer and the second passivation layer is an optical clear adhesive (OCA) such as a transparent acrylic adhesive. In one embodiment of the present disclosure, the thicknesses of the first and second passivation layers are about 10-100 µm.

### Embodiment 1

A PET transparent substrate is provided, and then the top surface and the bottom surface of the PET transparent substrate are performed the following steps at the same time. A nickel-chromium alloy is sputtered on the PET transparent substrate as tie coat layers with about 20 nm. Then, a zinc-copper alloy is sputtered on the tie coat layers as dielectric layers, so as to enhance the binding strength between the nickel-chromium alloy and a copper metal.

And then, the copper metal is electroplated on the dielectric layers by an electroplating process, so as to form metal conductive layers. In this embodiment, the thicknesses of the metal conductive layers are about 0.7 µm. The components of an electroplating solution for forming the aforementioned metal conductive layer are shown on Table 1.

**Table 1: components of electroplating solution for forming metal conductive layer**

| Components | Concentration |
|---|---|
| CuSO₄ · 5H₂O | 100 g/L |
| H₂SO₄ | 180 g/L |
| HCl | 50 ppm |
| Additive A^{a} | 10 g/L |
| Additive B^{b} | trace amount |
| Additive C^{c} | 0.75 mL/L |

| | |
|---|---|
| Note: the temperature of electroplating is 45°C ^{a}Additive A bought from EBARA (Japan), model: CU-BRITE RF MU ^{b}Additive B bought from EBARA (Japan), model: CU-BRITE RF-A ^{c}additive C bought from EBARA (Japan), model: CU-BRITE RF-B | |

An electroplating process is following performed to individually electroplate anti-reflective layers on the metal conductive layers. In this embodiment, the thicknesses of the anti-reflective layers are about 0.1 µm, and the materials thereof are a black nickel zinc sulfide. The components of an electroplating solution for forming the aforementioned nickel zinc mixture are shown on Table 2.

**Table 2: components of electroplating solution for forming nickel zinc mixture**

| Components | Concentration (g/L) |
|---|---|
| NiSO₄ · 7H₂O | 80 |
| ZnSO₄ · 7H₂O | 45 |
| NH₄SCN | 30 |
| H₃BO₃ | 30 |
| NiSO₄(NH₄)SO₄ · 6H₂O | 50 |

| | |
|---|---|
| Note: when the pH value of the electroplating solution is 5.0, the color of the electroplating solution is closed to black. | |

**Table 3: the CIE coordinates of the tie coat layers and the anti-reflective layers in embodiment 1**

| | CIE coordinates | | |
|---|---|---|---|
| | L* | a* | b* |
| tie coat layers | 13 | 0.13 | 0.73 |
| anti-reflective layers | 12 | -0.15 | -0.01 |

Table 3 illustrates that, the CIE coordinates of the tie coat layers and anti-reflective layers in this embodiment are all closed to black, so as to absorb reflective light or scattering light, and to reduce light diffraction.

A lithography process is following used to etch the tie coat layers, dielectric layers, metal conductive layers and anti-reflective layers, so as to form a mesh structure. In this embodiment, the line width of the mesh structure is about 4 µm. And then, an optical clear adhesive covers on the anti-reflective layer to be a passivation layer, and a copper metal mesh structure is obtained. The copper metal mesh structure may be applied into a touch panel as a sensor.

The metal atoms proportions and the oxygen atom contents of the layers of the transparent conductive structure is measured by ICP and element analyzer, so that the surface resistance and line resistance of the transparent conductive structure can be regulated (referred to Table 4), and the CIE data of the layers of the transparent conductive structure.

**Table 4*: surface resistance, line resistance and light-transmittance of embodiment 1**

| | surface resistance (Ω/□) | line resistance (Ω) | light-transmittance (%) |
|---|---|---|---|
| embodiment 1 | 0.07 | <800 | 88 |

| | | | |
|---|---|---|---|
| * Table 4 is illustrated the surface resistance, line resistance and light-transmittance of a 13-inch transparent conductive structure in embodiment 1. | | | |

### Embodiment 2 (not forming part of the present invention)

In embodiment 2, the tie coat layers are oxygen-containing molybdenum compound, and the material of the anti-reflective layers is molybdenum oxide. The method of embodiment 2 and the materials of the other layers are same as embodiment 1, so there is no need to go into details.

The metal atoms proportions and the oxygen atom contents of the layers of the transparent conductive structure is measured by ICP-AES and element analyzer, so that the surface resistance and line resistance of the transparent conductive structure can be regulated, and the CIE data of the layers of the transparent conductive structure (referred to Table 5-6).

**Table 5: the CIE coordinates of the tie coat layers and the anti-reflective layers in embodiment 2**

| | CIE coordinates | | |
|---|---|---|---|
| | L* | a* | b* |
| tie coat layers | 28 | -4.8 | -3.8 |
| anti-reflective layers | 23 | -6.5 | -12.6 |

Table 5 illustrates that, the color of the tie coat layers is closed to deep-blue, and the color of the anti-reflective layers is also closed to deep-blue.

**Table 6*: surface resistance, line resistance and light-transmittance of embodiment 2**

| | surface resistance (Ω/□) | line resistance (Ω) | light-transmittance (%) |
|---|---|---|---|
| embodiment 2 | 0.06 | <700 | 88 |

| | | | |
|---|---|---|---|
| * Table 6 is illustrated the surface resistance, line resistance and light-transmittance of a 13-inch transparent conductive structure in embodiment 2. | | | |

The surface resistance of the transparent conductive structure according to various embodiments of the present disclosure is about 0.01-1 Ω/□, and the line resistance thereof is less than 700 Ω. The surface resistance and line resistance of the transparent conductive structure in this embodiment are both much less than the surface resistance (100-400 Ω/□) and line resistance (>10,000 Ω) of ITO. Therefore, the transparent conductive structure according various embodiments of the present disclosure has lower surface resistance and higher conductivity. As applied into a touch device, the transparent conductive structure according to embodiments of the present disclosure has better sensitivity. In another aspect, because the top and bottom sides of the metal layer in the transparent conductive structure according to embodiments of the present disclosure are covered by the deep-blue or black dielectric layers and passivation layers, so as to prevent chromatic aberration occurred by light reflection, light scattering or light diffraction.

Otherwise, the metal layer of the transparent conductive structure according to embodiments of the present disclosure is made from copper as a conductive material. Compared to silver (Ag), copper has higher chemical stability, which is not easy to be oxidized or sulfidized to damage the transparent conductive structure, or to occur electrical failure. The cost of copper is lower than silver, so that the product cost may be significantly reduced.

## Claims

1. A transparent conductive structure with metal mesh, the transparent conductive structure comprising:
a transparent substrate having a top surface and a bottom surface opposite to the top surface;
a first mesh structure positioned on the top surface of the transparent substrate, wherein the first mesh structure from the top surface of the transparent substrate sequentially comprises:
a first tie coat layer, being made of a nickel-chromium alloy and formed on the top surface of the transparent substrate by way of sputtering;
a first dielectric layer, being made of a zinc-copper alloy and formed on the first tie coat layer by way of sputtering;
a first metal layer, being made of a copper and positioned on the first dielectric layer by way of electroplating; and
a first anti-reflective layer, being made of a nickel zinc sulfide and positioned on the first metal layer by way of electroplating; and
a second mesh structure positioned on the bottom surface of the transparent substrate, wherein the second mesh structure from the bottom surface of the transparent substrate sequentially comprises:
a second tie coat layer, being made of a nickel-chromium alloy and formed on the bottom surface of the transparent substrate by way of sputtering
a second dielectric layer, being made of a zinc-copper alloy and formed on the second tie coat layer by way of sputtering;
a second metal layer, being made of a copper and positioned on the second dielectric layer by way of electroplating; and
a second anti-reflective layer, being made of a nickel zinc sulfide and positioned on the second metal layer by way of electroplating.

2. The transparent conductive structure of claim 1, wherein the line widths of the first mesh structure and the second mesh structure are about 2-15µm.

3. The transparent conductive structure of claim 1, wherein the transparent substrate is a rigid substrate or a flexible substrate.

4. The transparent conductive structure of claim 3, wherein the rigid substrate comprises glass, fiber-glass or hard plastic.

5. The transparent conductive structure of claim 3, wherein the flexible substrate comprises polyethylene (PE), polyethylene terephthalate (PET) or triacetyl cellulose (TAC).

6. The transparent conductive structure of claim 1, wherein the thicknesses of the first dielectric layer and the second dielectric layer are about 1-200 nm.

7. The transparent conductive structure of claim 1, wherein the thicknesses of the first anti-reflective layer and the second anti-reflective layer are about 5-1,000 nm.

8. The transparent conductive structure of claim 1, wherein the thicknesses of the first metal layer and the second metal layer are about 0.2-3.0 µm.

9. The transparent conductive structure of claim 1, wherein the thicknesses of the first tie coat layer and the second tie coat layer are about 1-200 nm.

10. The transparent conductive structure of claim 1, wherein the first mesh structure further comprises a first passivation layer covering the first anti-reflective layer; and the second mesh structure further comprises a second passivation layer covering the second anit-reflective layer.

11. The transparent conductive structure of claim 10, wherein the materials of the first passivation layer and the second passivation layer is an optical clear adhesive (OCA).

12. The transparent conductive structure of claim 11, wherein the OCA is a transparent acrylic adhesive.

13. The transparent conductive structure of claim 10, wherein the thicknesses of the first passivation layer and the second passivation layer are about 10-100µm.

## Patentansprüche

1. Transparente leitfähige Struktur mit einem Metallnetz, wobei die transparente leitfähige Struktur umfasst:
ein transparentes Substrat, mit einer oberen Fläche und einer unteren Fläche gegenüber der oberen Fläche;
eine erste Netzstruktur, die auf der oberen Fläche des transparenten Substrats positioniert ist, wobei die erste Netzstruktur der Reihe nach von der oberen Fläche des transparenten Substrats umfasst:
eine erste Haftgrundschicht, die aus einer Nickel-Chrom-Legierung hergestellt und auf der oberen Fläche des transparenten Substrats mittels Sputterns gebildet ist;
eine erste dielektrische Schicht, die aus einer Zink-Kupfer-Legierung hergestellt und auf der ersten Haftgrundschicht mittels Sputterns gebildet ist;
eine erste Metallschicht, die aus einem Kupfer hergestellt und auf der ersten dielektrischen Schicht mittels Elektroplattierens positioniert ist; und
eine erste Antireflexschicht, die aus einem Nickel-Zink-Sulfid hergestellt und auf der ersten Metallschicht mittels Elektroplattierens positioniert ist; und
eine zweite Netzstruktur, die auf der unteren Fläche des transparenten Substrats positioniert ist, wobei die zweite Netzstruktur der Reihe nach von der unteren Fläche des transparenten Substrats umfasst:
eine zweite Haftgrundschicht, die aus einer Nickel-Chrom-Legierung hergestellt und auf der unteren Fläche des transparenten Substrats mittels Sputterns gebildet ist;
eine zweite dielektrische Schicht, die aus einer Zink-Kupfer-Legierung hergestellt und auf der zweiten Haftgrundschicht mittels Sputterns gebildet ist;
eine zweite Metallschicht, die aus einem Kupfer hergestellt und auf der zweiten dielektrischen Schicht mittels Elektroplattierens positioniert ist; und
eine zweite Antireflexschicht, die aus einem Nickel-Zink-Sulfid hergestellt und auf der zweiten Metallschicht mittels Elektroplattierens positioniert ist.

2. Transparente leitfähige Struktur nach Anspruch 1, wobei die Leitungsbreiten der ersten Netzstruktur und der zweiten Netzstruktur ungefähr 2-15 µm betragen.

3. Transparente leitfähige Struktur nach Anspruch 1, wobei das transparente Substrat ein steifes Substrat oder ein flexibles Substrat ist.

4. Transparente leitfähige Struktur nach Anspruch 3, wobei das steife Substrat Glas, Fiberglas oder Hartplastik umfasst.

5. Transparente leitfähige Struktur nach Anspruch 3, wobei das flexible Substrat Polyethylen (PE), Polyethylenterephthalat (PET) oder Triacetylcellulose (TAC) umfasst.

6. Transparente leitfähige Struktur nach Anspruch 1, wobei die Dicken der ersten dielektrischen Schicht und der zweiten dielektrischen Schicht ungefähr 1-200 nm betragen.

7. Transparente leitfähige Struktur nach Anspruch 1, wobei die Dicken der ersten Antireflexschicht und der zweiten Antireflexschicht ungefähr 5-1.000 nm betragen.

8. Transparente leitfähige Struktur nach Anspruch 1, wobei die Dicken der ersten Metallschicht und der zweiten Metallschicht ungefähr 0,2-3,0 µm betragen.

9. Transparente leitfähige Struktur nach Anspruch 1, wobei die Dicken der ersten Haftgrundschicht und der zweiten Haftgrundschicht ungefähr 1-200 nm betragen.

10. Transparente leitfähige Struktur nach Anspruch 1, wobei die erste Netzstruktur weiterhin eine erste Passivierungsschicht umfasst, die die erste Antireflexschicht überdeckt; und die zweite Netzstruktur weiterhin eine zweite Passivierungsschicht umfasst, die die zweite Antireflexschicht überdeckt.

11. Transparente leitfähige Struktur nach Anspruch 10, wobei die Materialien der ersten Passivierungsschicht und der zweiten Passivierungsschicht ein optisch klarer Kleber (OCA) ist.

12. Transparente leitfähige Struktur nach Anspruch 11, wobei der OCA ein transparenter Acrylkleber ist.

13. Transparente leitfähige Struktur nach Anspruch 10, wobei die Dicken der ersten Passivierungsschicht und der zweiten Passivierungsschicht ungefähr 10-100 µm betragen.

## Revendications

1. Structure conductrice transparente avec un treillis métallique, la structure conductrice transparente comprenant :
un substrat transparent ayant une surface supérieure et une surface inférieure opposée à la surface supérieure ;
une première structure de treillis positionnée sur la surface supérieure du substrat transparent, dans laquelle la première structure de treillis comprend séquentiellement à partir de la surface supérieure du substrat transparent :
une première couche de couche d'accrochage, faite en alliage nickel-chrome et formée sur la surface supérieure du substrat transparent par pulvérisation ;
une première couche diélectrique, faite en un alliage zinc-cuivre et formée sur la première couche d'accrochage par pulvërisation ;
une première couche de métal, faite en cuivre et
positionnée sur la première couche diélectrique par galvanoplastie ; et
une première couche antireflet, faite en sulfure de nickel et de zinc et positionnée sur la première couche de métal par galvanoplastie ; et
une seconde structure de treillis positionnée sur la surface inférieure du substrat transparent,
dans laquelle la seconde structure de treillis comprend séquentiellement à partir de la surface inférieure du substrat transparent :
une seconde couche de couche d'accrochage, faite en alliage nickel-chrome et formée sur la surface inférieure du substrat transparent par pulvérisation ;
une seconde couche diélectrique, faite en un alliage zinc-cuivre et formée sur la seconde couche d'accrochage par pulvérisation ;
une seconde couche de métal, faite en cuivre et positionnée sur la seconde couche diélectrique par galvanoplastie ; et
une seconde couche antireflet, faite en sulfure de nickel et de zinc et positionnée sur la seconde couche de métal par galvanoplastie.

2. Structure conductrice transparente selon la revendication 1, dans laquelle les largeurs de ligne de la première structure de treillis et de la seconde structure de treillis sont d'environ 2 à 15 µm.

3. Structure conductrice transparente selon la revendication 1, dans laquelle le substrat transparent est un substrat rigide ou un substrat flexible.

4. Structure conductrice transparente selon la revendication 3, dans laquelle le substrat rigide comprend du verre, de la fibre de verre ou un plastique dur.

5. Structure conductrice transparente selon la revendication 3, dans laquelle le substrat flexible comprend du polyéthylène (PE), du téréphtalate de polyéthylène (PET) ou de la triacétyl cellulose (TAC).

6. Structure conductrice transparente selon la revendication 1, dans laquelle les épaisseurs de la première couche diélectrique et de la seconde couche diélectriques sont d'environ 1 à 200 nm.

7. Structure conductrice transparente selon la revendication 1, dans laquelle les épaisseurs de la première couche antireflet et de la seconde couche antireflet sont d'environ 5 à 1 000 nm.

8. Structure conductrice transparente selon la revendication 1, dans laquelle les épaisseurs de la première couche de métal et de la seconde couche de métal sont d'environ 0,2 à 3,0 µm.

9. Structure conductrice transparente selon la revendication 1, dans laquelle les épaisseurs de la première couche de couche d'accrochage et de la seconde couche de couche d'accrochage sont d'environ 1 à 200 nm.

10. Structure conductrice transparente selon la revendication 1, dans laquelle la première structure de treillis comprend en outre une première couche de passivation couvrant la première couche antireflet ; et la seconde structure de treillis comprend en outre une seconde couche de passivation couvrant la seconde couche antireflet.

11. Structure conductrice transparente selon la revendication 10, dans laquelle les matériaux de la première couche de passivation et de la seconde couche de passivation sont un adhésif optiquement transparent (OCA).

12. Structure conductrice transparente selon la revendication 11, dans laquelle l'OCA est un adhésif acrylique transparent.

13. Structure conductrice transparente selon la revendication 10, dans laquelle les épaisseurs de la première couche de passivation et de la seconde couche de passivation sont d'environ 10 à 100 µm.
